(19) Europäisches Patentamt / European Patent Office / Office européen des brevets

(11) **EP 1 362 419 B1**

(12) **FASCICULE DE BREVET EUROPEEN**

(45) Date de publication et mention de la délivrance du brevet:
**08.12.2010 Bulletin 2010/49**

(21) Numéro de dépôt: **02702470.2**

(22) Date de dépôt: **11.02.2002**

(51) Int Cl.:
*H03G 1/00* (2006.01)      *H03F 3/45* (2006.01)

(86) Numéro de dépôt international:
**PCT/FR2002/000510**

(87) Numéro de publication internationale:
**WO 2002/065637 (22.08.2002 Gazette 2002/34)**

(54) **CIRCUIT DE NORMALISATION A TENSION D'ERREUR REDUITE**

SCHALTUNG ZUR NORMALISIERUNG MIT REDUZIERTER FEHLERSPANNUNG

NORMALIZING CIRCUIT WITH REDUCED ERROR VOLTAGE

(84) Etats contractants désignés:
**FR GB**

(30) Priorité: **13.02.2001 FR 0101931**

(43) Date de publication de la demande:
**19.11.2003 Bulletin 2003/47**

(73) Titulaire: **STMicroelectronics S.A.**
**92120 Montrouge (FR)**

(72) Inventeurs:
- **MONCEAU, Laurent**
  **F-38320 Eybens (FR)**
- **DUBOIS, Catherine**
  **F-38100 Grenoble (FR)**

(74) Mandataire: **de Beaumont, Michel**
**Cabinet Michel de Beaumont**
**1, rue Champollion**
**38000 Grenoble (FR)**

(56) Documents cités:
**EP-A- 0 874 453**    **EP-A- 0 993 110**
**US-A- 4 546 327**    **US-A- 5 132 559**
**US-A- 5 153 529**

- **"NOTES ON AN INSTRUMENTATION VCA" ELECTRONIC ENGINEERING, MORGAN-GRAMPIAN LTD. LONDON, GB, vol. 66, no. 812, 1 août 1994 (1994-08-01), pages 18-19, XP000468701 ISSN: 0013-4902**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

**EP 1 362 419 B1**

**Description**

La présente invention concerne un circuit pour normaliser un signal, c'est-à-dire pour fournir, à partir d'un signal d'entrée, un signal compris dans une plage prédéterminée.

Les applications de tels circuits sont variées. Par exemple, des circuits de normalisation sont utilisés dans les systèmes de lecture de disques optiques. Dans ces systèmes, un circuit de normalisation est disposé entre un photodétecteur et un convertisseur analogique-numérique afin d'adapter le signal issu du photodétecteur à la plage d'entrée du convertisseur analogique-numérique. Le circuit intégré "L6300" de la société STMicroelectronics est un exemple de circuit de normalisation utilisé dans un tel système. Voir aussi par exemple EP0,993,110.

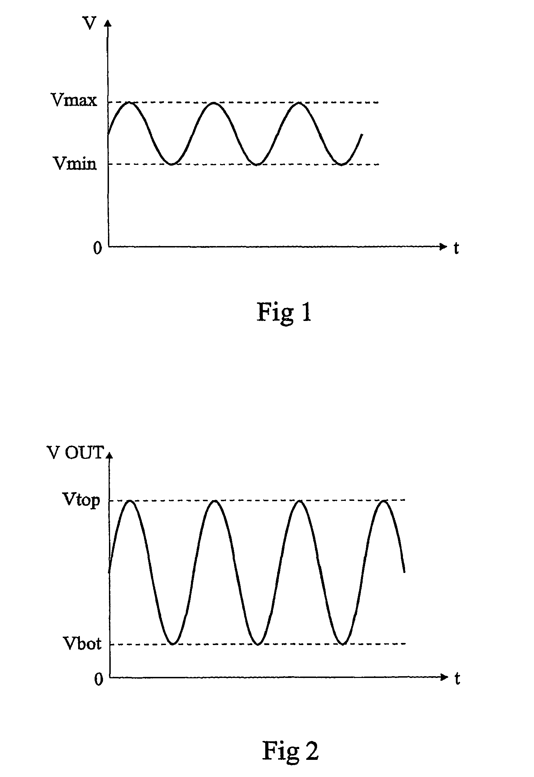

La figure 1 illustre l'allure, en fonction du temps, d'une tension V à l'entrée d'un circuit de normalisation. La tension V, représentée sous la forme d'une sinusoïde, oscille entre une valeur minimale Vmin et une valeur maximale Vmax. Dans l'application évoquée, la tension V issue d'un photodétecteur oscille au-dessus d'un niveau de référence Vmin approximativement égal à 2,5 volts. L'amplitude crête à crête Vmax-Vmin de la tension V peut varier dans une plage importante allant de 25 à 500 millivolts, selon que le photodétecteur reçoit tout ou partie de la lumière émise par le laser.

La figure 2 illustre l'allure, en fonction du temps, de la tension VOUT en sortie du circuit de normalisation. La tension VOUT est de même fréquence que la tension V, mais son amplitude est constante et le signal oscille entre une valeur minimale Vbot et une valeur maximale Vtop correspondant à des valeurs extrêmes souhaitées. Des valeurs typiques de Vbot et Vtop, dans l'application évoquée ci-dessus, se situent respectivement aux alentours de 125 et 875 millivolts.

De façon générale, la réalisation d'un circuit de normalisation doit tenir compte de tensions d'erreur ou d'offset susceptibles d'affecter les valeurs extrêmes de la tension de sortie VOUT. Par exemple, dans l'application évoquée, une tension d'erreur qui peut aller jusqu'à $\pm$ 70 millivolts affecte systématiquement le niveau de référence Vmin. De plus, chaque élément du circuit de normalisation introduit une tension d'erreur qui lui est propre. Cet effet est particulièrement sensible si le circuit comprend des transistors MOS, car ces transistors produisent des tensions d'erreur plus importantes que les transistors bipolaires.

Pour cela, de nombreux circuits de normalisation, comme le circuit "L6300" évoqué ci-dessus, sont réalisés à l'aide de transistors bipolaires. En outre, comme les circuits de traitement du signal qui suivent le circuit de normalisation sont généralement réalisés à l'aide de transistors CMOS, le circuit de normalisation peut difficilement être réalisé conjointement avec les circuits qui le suivent sur une même plaquette de silicium pour former un seul circuit intégré. Il en résulte des temps et des coûts de fabrication, de test et d'interconnexion élevés.

En outre, les circuits de normalisation connus sont alimentés par des tensions d'alimentation relativement élevées, supérieures à celles qui alimentent les circuits CMOS.

Un objet de la présente invention est de prévoir un circuit de normalisation dans lequel l'effet des tensions d'erreur est diminué.

Un autre objet de la présente invention est de prévoir un circuit de normalisation pouvant facilement être réalisé sur un même circuit intégré qu'un circuit de traitement numérique du signal.

Un autre objet de la présente invention est de prévoir un circuit de normalisation pouvant être alimenté sous une tension réduite.

Un autre objet de la présente invention est de prévoir un circuit de normalisation compact.

Pour atteindre ces objets ainsi que d'autres, la présente invention prévoit un circuit pour normaliser un signal de tension. Le circuit comprend :

- un premier convertisseur tension-courant recevant un signal de tension à normaliser et une tension de référence, et fournissant un courant proportionnel à la différence de tension entre la tension du signal à normaliser et la tension de référence,
- un premier amplificateur de courant attaqué par le premier convertisseur tension-courant,
- un deuxième convertisseur tension-courant recevant une tension de réglage et la tension de référence et fournissant un courant proportionnel à la différence de tension entre la tension de réglage et la tension de référence,
- un deuxième amplificateur de courant attaqué par le deuxième convertisseur tension-courant, et
- un moyen pour fournir un signal de tension normalisé à partir de la différence des courants fournis par les premier et deuxième amplificateurs de courant.

Selon un mode de réalisation de la présente invention, le moyen pour fournir le signal de tension normalisé comprend :

- un moyen de conversion de courant attaqué par le deuxième amplificateur de courant et fournissant un courant de même amplitude et de sens opposé au courant qu'il reçoit, et

- un convertisseur courant-tension attaqué par le premier amplificateur de courant et par le moyen de conversion de courant et fournissant le signal de tension normalisé.

Selon un mode de réalisation de la présente invention, les premier et deuxième amplificateurs de courant sont de constitution identique, de même que les premier et deuxième convertisseurs tension-courant.

Selon un mode de réalisation de la présente invention, les premier et deuxième amplificateurs de courant sont à gain variable et leur gain est commandé de manière identique.

Selon un mode de réalisation de la présente invention, chacun des premier et deuxième amplificateurs de courant comprend plusieurs modules amplificateurs.

Selon un mode de réalisation de la présente invention, chacun des premier et deuxième amplificateurs de courant comprend un premier module et un deuxième module, le deuxième module assurant un gain en courant égal à 1 ou à 9.

Selon un mode de réalisation de la présente invention, le premier module comprend :

un noeud d'entrée couplé à la masse par l'intermédiaire d'un transistor connecté en diode, de 16 branches identiques constituées chacune d'un transistor, et de 31 branches identiques comprenant chacune un transistor en série avec un interrupteur, chacun des transistors couplés au noeud d'entrée étant traversé, lorsqu'il conduit, par un même courant, et

un noeud de sortie couplé à la masse par l'intermédiaire de 16 branches identiques constituées chacune d'un transistor, et de 31 branches identiques comprenant chacune un transistor en série avec un interrupteur, chacun des transistors couplés au noeud de sortie étant traversé, lorsqu'il conduit, par un courant de même valeur qu'un quelconque, passant, des transistors couplés au noeud d'entrée.

Selon un mode de réalisation de la présente invention, la tension de réglage est réglable et sert à régler la valeur minimale du signal normalisé.

Selon un mode de réalisation de la présente invention, le circuit comporte une première source de courant disposée entre la sortie du premier convertisseur tension-courant et une tension fixe, et une deuxième source de courant disposée entre la sortie du deuxième convertisseur tension-courant et ladite tension fixe.

La présente invention prévoit également, un procédé pour normaliser un signal à l'aide d'un circuit comprenant une première branche recevant le signal à normaliser et une deuxième branche recevant une tension de réglage, la première branche comportant un premier amplificateur de courant à gain variable et la deuxième branche comportant un deuxième amplificateur de courant à gain variable, les premier et deuxième amplificateurs de courant étant de constitution identique et leur gain étant réglé de la même façon. Le procédé comporte les étapes de réglage suivantes :

a) le gain des premier et deuxième amplificateurs de courant étant réglé au maximum, injecter dans le circuit une tension égale à la valeur minimale de la tension à normaliser et régler la tension de réglage pour que le niveau minimal du signal en sortie du circuit corresponde au niveau minimum souhaité, puis

b) injecter le signal à normaliser et régler le gain des premier et deuxième amplificateurs de courant pour que le niveau maximal du signal en sortie du circuit corresponde au niveau maximal souhaité.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :

la figure 1 illustre l'allure d'une tension d'entrée d'un circuit de normalisation ;
la figure 2 illustre l'allure de la tension de sortie d'un circuit de normalisation ;
la figure 3 représente, sous forme de blocs, un circuit de normalisation selon la présente invention ;
la figure 4 représente un mode de réalisation d'un élément du circuit de la figure 3 ;
la figure 5 représente le graphe courant-tension d'un élément du circuit de la figure 3 ;
la figure 6 représente le graphe tension-courant d'un élément du circuit de la figure 3 ;
les figures 7, 8 et 9 représentent des exemples de réalisation d'éléments du circuit de la figure 3.

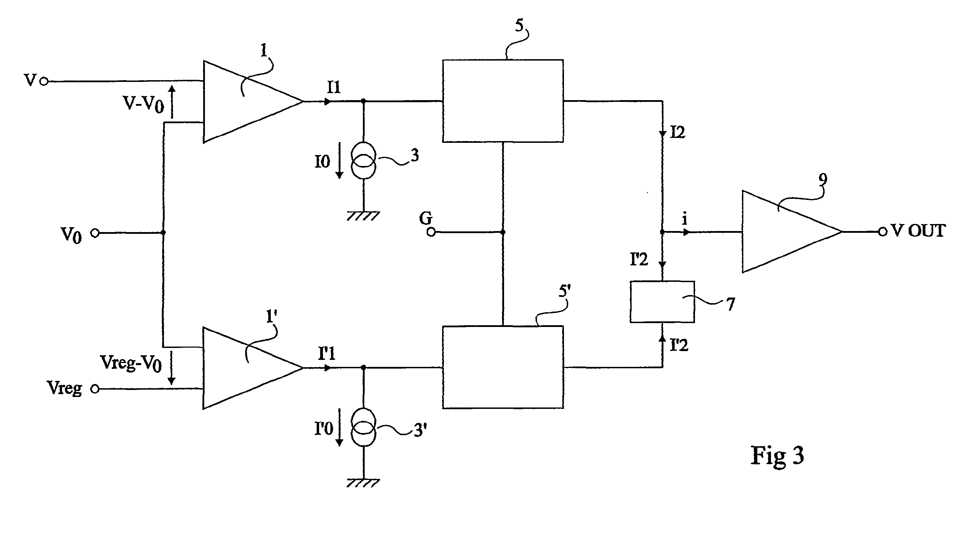

En figure 3, une tension V à normaliser attaque un convertisseur tension-courant 1. Le convertisseur tension-courant 1 reçoit également une tension de référence $V_0$ et il fournit un courant I1 qui varie proportionnellement à la différence $V-V_0$. Comme on le verra par la suite, l'expression générale du courant I1 est I1 = Im + k1. $(V-V_0)$, Im et k1 étant des constantes. Une source de courant 3 est connectée en sortie du convertisseur tension-courant 1 et dérive un courant constant 10 vers la masse du circuit. La sortie du convertisseur tension-courant 1 est connectée à un amplificateur de courant 5. L'amplificateur de courant 5 est un amplificateur à gain variable et son gain G est commandé par une borne de commande, également notée G. L'amplificateur de courant 5 fournit un courant 12 égal à G x (I1-I0) . Les éléments 1, 3, et 5 constituent une première branche du circuit de normalisation.

Le circuit de normalisation comprend une deuxième branche de même constitution que la première branche. Ainsi, la deuxième branche comprend un convertisseur tension-courant 1', une source de courant 3' et un amplificateur de courant 5'. Le convertisseur tension-courant 1' reçoit une tension de réglage Vreg et la tension de référence $V_0$. Le convertisseur tension-courant 1' fournit un courant I'1 d'expression I'1 = I'm + k'1.(Vreg - $V_0$), I'm et k'1 étant des constantes. Une partie du courant I'1 est dérivée vers la masse par la source de courant 3', traversée par un courant I'0. Le convertisseur tension-courant l'attaque l'amplificateur de courant 5', qui fournit un courant I'2. L'amplificateur de courant 5' est un amplificateur de courant à gain variable. Son gain G' est commandé par une borne de commande reliée, en figure 3, à la borne de commande G de l'amplificateur 5. Le courant I'2 est égal à G' x (I'1-I'0).

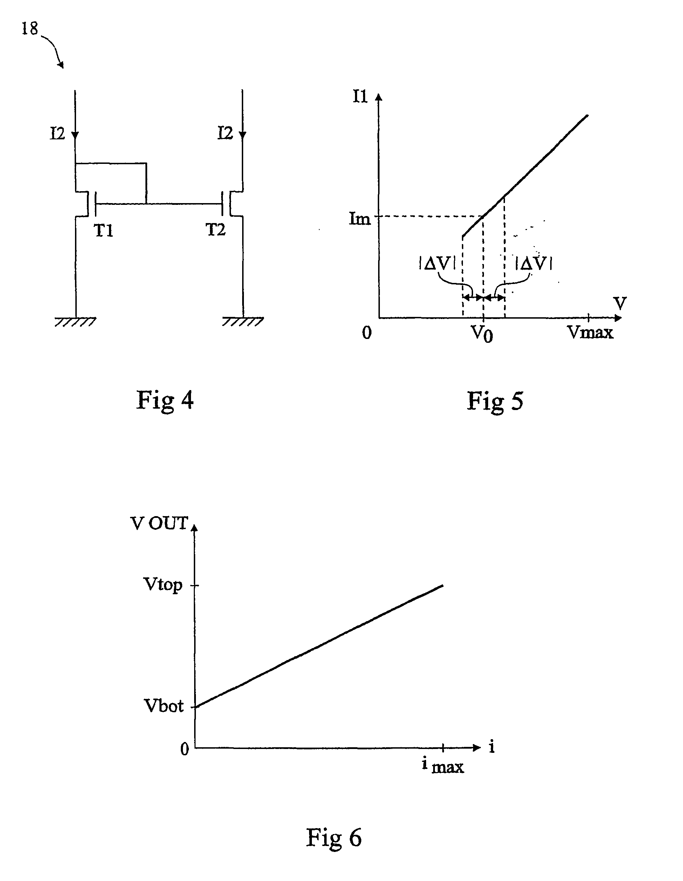

La sortie de l'amplificateur de courant 5' attaque un module de conversion de courant 7. Le module de conversion de courant 7 fournit en sortie un courant I'2 de même amplitude que le courant I'2 qu'il reçoit, mais de sens opposé. Le module 7 peut être réalisé à l'aide d'un miroir de courant, comportant par exemple deux transistors MOS T1 et T2 connectés en parallèle et dont un est monté en diode, comme cela est illustré en figure 4.

La sortie de l'amplificateur de courant 5 et la sortie du module 7 sont reliées ensemble à l'entrée d'un convertisseur courant-tension 9. Le convertisseur courant-tension 9 reçoit un courant i égal à la différence des courants I2-I'2. Le convertisseur courant-tension 9 fournit une tension VOUT correspondant à la tension V d'entrée, mais dont les valeurs extrêmes Vbot et Vtop, correspondent aux valeurs souhaitées.

Les sources de courant 3 et 3' sont optionnelles. Elles servent à dériver vers la masse une partie de la composante continue des courants I1 et I'1. Cela permet à l'amplificateur de courant 5 d'agir sur des signaux plus faibles. L'amplificateur 5 est ainsi plus facile à réaliser. Il peut être réalisé à l'aide de composants plus petits et consomme moins.

De manière avantageuse, les éléments 1', 3', 5' de la deuxième branche du circuit sont de constitution identique aux éléments 1, 3, 5, respectivement, de la première branche du circuit. Cela permet une réalisation aisée du circuit de normalisation et de compenser diverses dérives, comme on le verra par la suite.

La figure 5 illustre la caractéristique courant/tension du convertisseur tension-courant 1. Le courant I1 figure en ordonnée et la tension V figure en abscisse. De préférence, la tension $V_0$ est choisie aussi proche que possible de la valeur minimale Vmin de la tension V à normaliser. La valeur inférieure Vmin de la tension V est ainsi égale à $V_0$ + $\Delta V$, $\Delta V$ étant une tension d'erreur positive ou négative. Comme cela a été mentionné, le courant I1 est donné par l'expression I1 = Im + k1 (V - $V_0$). Lorsque la tension d'entrée est égale à $V_0$, le courant I1 fourni en sortie est égal au courant Im. Le courant Im est choisi de façon à obtenir de bonnes performances en bruit du circuit de normalisation. Dans un exemple de réalisation pratique, le courant Im a été choisi égal à 500 μA.

La figure 6 illustre la caractéristique tension/courant du convertisseur courant-tension 9. Cette caractéristique est telle que, lorsque le courant i entrant dans le convertisseur 9 est égal à 0, la tension de sortie VOUT est égale à Vbot. Lorsque le courant i est maximal ($i_{max}$) la tension de sortie VOUT est égale à Vtop. On a VOUT = Vbot + k2.i, k2 étant un coefficient propre au convertisseur 9.

Le fonctionnement du circuit de normalisation de la figure 3 va maintenant être expliqué. La tension V correspond au graphe de la figure 1, et la tension VOUT fournie par le circuit de normalisation doit être comprise entre les niveaux Vbot et Vtop de la figure 2. Le réglage des valeurs extrêmes de la tension à fournir se fait en deux temps.

D'abord, on règle le niveau minimal de la tension VOUT. Pour ce faire, une tension égale à Vmin est appliquée à l'entrée du circuit. Commue la tension $V_0$ est sensiblement égale à la tension Vmin, la tension V correspond à $V_0$ plus une tension de décalage positive ou négative, $\Delta V$, faible devant $V_0$. Le gain G est réglé au maximum. On observe alors la valeur de la tension VOUT en sortie du circuit de normalisation et on règle la tension de réglage Vreg de façon à obtenir Vbot en sortie. Le réglage de Vreg peut être réalisé de toute manière appropriée. Par exemple, le réglage de Vreg se fera automatiquement à l'aide d'un module couplé à la sortie VOUT.

En considérant que G=Gmax et que les éléments 1', 3' et 5' sont respectivement identiques aux éléments 1, 3 et 5 (Im=I'm, I0=I'0, k1=k'1., k2=k'2), on a :

$$I1^{'} = Im + k1. \; \Delta V$$

$$I2 = Gmax.(I1 - I0) = Gmax.(Im - I0 + k1.\Delta V) + Ioffset$$

Ioffset étant un courant d'erreur provoqué par les éléments de la première branche du circuit.

On a également:

$$I'1 = I'm + k'1.(Vreg - V_0)$$

$$I'2 = Gmax.(I'1-I'0)$$
$$= Gmax.(I'm - I'0 + k1.[Vreg - V_0]) + I'offset$$

l'offset étant un courant d'erreur provoqué par les éléments de la deuxième branche du circuit.

L'expression de VOUT est :

$$VOUT = Vbot + k2.i = Vbot + k2.(I2 - I'2)$$

soit, avec Im=I'm, 10=I'0, k1=k'1 et k2=k'2 :

$$VOUT = Vbot + k1.k2.Gmax[\Delta V - (Vreg-V_0)] + k2(Ioffset-I'offset).$$

Comme on règle Vreg pour que VOUT soit égal à Vbot, on a :

$$k1.k2.Gmax.(\Delta V + V_0 - Vreg) + k2(Ioffset - I'offset) = 0,$$

soit

$$Vreg = V_0 + \Delta V + \frac{(I_{offset} - I'_{offset})}{k_1 \, G_{max}}.$$

Lorsque le réglage de la tension Vreg est effectué, on ne le modifie plus jusqu'à ce qu'une nouvelle tension V soit à normaliser. On règle alors le niveau maximal de la tension de sortie VOUT. Pour cela, on applique la tension Vmax à l'entrée du circuit de normalisation. En agissant sur la borne de commande G, on règle le gain des amplificateurs 5 et 5' de sorte que la valeur maximale du signal VOUT soit égale à Vtop. Le gain G sera réglé par un moyen quelconque approprié. Par exemple, un module numérique adéquat couplé à la sortie du circuit attaquera la borne G et réglera le gain automatiquement.

Après le réglage du gain G, le réglage des limites extrêmes de VOUT est terminé et l'on ne modifiera plus les réglages, jusqu'à ce que l'on souhaite normaliser une nouvelle tension présentant des valeurs différentes de Vmin et/ou Vmax.

En fonctionnement normal, on a :

$$I1 = Im + k1 \, (V - V_0)$$

$$I2 = G.(I1 - I0) = G.(Im - I0 + k1.V - k1.V_0) + Ioffset$$

On a aussi :

$$I'1 = I'm + k'1.(Vreg - V_0)$$

$$I'2 = G.(I'1 - I'0) = G.(I'm - I'0 + k'1.[Vreg - V_0]) + I'offset$$

Par ailleurs, VOUT = Vbot + k2.(I2 - I'2).

Comme Im = I'm, k1 = k'1 et 10 = I'0, on a :

$$\texttt{VOUT = Vbot + k1.k2.G.(V - Vreg) + k2.(Ioffset - I'offset)}$$

Comme $\texttt{Vreg} = \texttt{V}_0 + \Delta\texttt{V} + \dfrac{(\texttt{I}_{\text{offset}} - \texttt{I'}_{\text{offset}})}{\texttt{k}_1\ \texttt{G}_{\text{max}}}$ , on a :

$$\texttt{VOUT = Vbot + k1.k2.G.(V-V}_0\texttt{-}\Delta\texttt{V-[Ioffset-I'offset]/k1.Gmax)}$$
$$\texttt{+ k2.(Ioffset - I'offset)}$$

$(V - V_0 - \Delta V)$ représente la composante de la tension V au-dessus de la tension Vmin. Appelons la Ve.

On a donc :

$$\texttt{VOUT = Vbot + k1.k2.G.Ve + k2.(Ioffset-I'offset)(1 - G/Gmax)}.$$

S'il n'y avait pas de tension d'erreur dans la tension de sortie VOUT, VOUT serait seulement égale à la somme des deux premiers termes, à savoir Vbot + k1.k2.G.Ve. L'expression de VOUT indique clairement que la structure du circuit de normalisation selon la présente invention est telle que l'influence des tensions (courants) d'erreur introduits par la structure est très limitée. En effet, dans l'expression de la tension de sortie, les courants d'erreur sont multipliés par un facteur 1-G/Gmax, ce facteur étant compris entre 0 et 1 quel que soit le gain G.

Cela est particulièrement important en technologie utilisant des transistors MOS, car ce type de transistor génère des tensions d'erreur importantes. On notera que le réglage des valeurs extrêmes de la tension à normaliser est particulièrement simple, même dans le cas où le circuit est réalisé avec des transistors MOS.

En outre, comme les deux branches du circuit sont identiques, si un des courants I1, I2 varie pour une raison quelconque, par exemple par suite d'une variation de température ou de tension d'alimentation, l'autre des courants I1, I2 subit la même variation et cette variation n'affecte pas le courant i puisque les courants I1 et I2 se retranchent.

On notera que, comme la tension d'entrée est convertie en courant et que l'amplification est une amplification en courant, le circuit de normalisation de la présente invention n'écrête pas, même sous une faible tension d'alimentation. Par exemple, si la valeur maximale de V est de l'ordre de 3 volts, le circuit de normalisation de la présente invention peut être alimenté avec une tension d'alimentation aussi faible que 3,3 volts. A titre de comparaison, le circuit "L6300" mentionné ci-dessus est alimenté en 5 volts. Le circuit de normalisation de la présente invention peut être réalisé ainsi avec des petits transistors, il occupe une surface réduite et consomme peu.

En outre, le circuit de normalisation de la présente invention peut sans difficultés être réalisé en technologie CMOS, et donc être facilement réalisé sur un même circuit intégré conjointement avec d'autres circuits utilisant des transistors MOS. Il en résulte des gains de temps de fabrication, de test, d'interconnexion, etc., d'où globalement un coût réduit pour le circuit et une intégration plus poussée. Un circuit intégré comportant le circuit de normalisation selon la présente invention et des circuits numériques aval pourra d'ailleurs être alimenté avec diverses tensions d'alimentation, par exemple 3,3 volts pour la partie normalisation de signal et 1,8 volts pour la partie numérique.

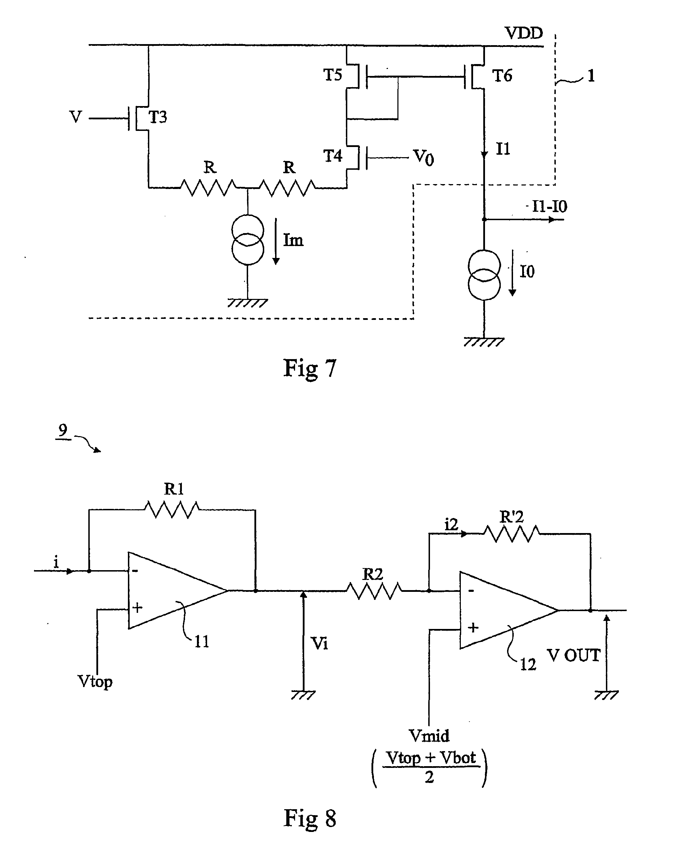

Les divers éléments du circuit de la figure 3 seront aisément réalisés par l'homme du métier. A titre d'exemple non-limitatif, les figures 7, 8 et 9 représentent respectivement des exemples de réalisation des éléments 1, 9 et 5 de la figure 3.

En figure 7, le convertisseur tension-courant 1 comporte deux transistors MOS T3 et T4 formant une paire différentielle. Les grilles respectives des transistors T3 et T4 sont attaquées par les tensions V et $V_0$. Les sources de ces transistors sont connectées ensemble par l'intermédiaire de résistances R et leur point de liaison est couplé à la masse par l'intermédiaire d'une source de courant traversée par le courant Im. Le drain du transistor T3 est connecté à une source de tension d'alimentation positive VDD et le drain du transistor T4 est connecté à un transistor monté en diode T5. Le transistor T5 forme, avec un transistor T6, un miroir de courant. Le courant I1 en sortie du convertisseur tension-courant 1 est fourni par la source du transistor T6. La figure 7 illustre en outre la source de courant I0 reliant la sortie du convertisseur 1 à la masse. L'exemple de la figure 7 n'est qu'un exemple seulement et son fonctionnement ne sera pas davantage expliqué.

La figure 8 illustre un exemple non limitatif de réalisation du convertisseur courant/tension 9. Un amplificateur opérationnel 11 reçoit le courant i sur son entrée inverseuse (-) et une tension égale à Vtop sur son entrée non inverseuse (+). L'entrée inverseuse de l'amplificateur 11 est couplée à la sortie de l'amplificateur 11 par l'intermédiaire d'une résistance R1. La tension Vi présente entre la sortie de l'amplificateur 11 et la masse est égale à Vtop - R1.i. Le convertisseur courant-tension 9 comprend un deuxième étage attaqué par la tension Vi. Ce deuxième étage comprend un amplificateur opérationnel 12 dont l'entrée inverseuse (-) est reliée à la sortie de l'amplificateur 11 par l'intermédiaire d'une résistance R2. L'entrée non inverseuse (+) de l'amplificateur 12 reçoit une tension Vmid égale à (Vtop + Vbot)/2. L'entrée inverseuse de l'amplificateur 12 est couplée à la sortie de l'amplificateur 12 par l'intermédiaire d'une résistance R'2 égale à R2. La tension de sortie VOUT est égale à Vmid - R2.i2, i2 étant le courant traversant la résistance R'2. Comme Vi est égal à R2.i2 + Vmid, on a VOUT = 2Vmid - Vi, soit VOUT = Vbot + R1.i, ce qui correspond à la caractéristique de la figure 7, avec un coefficient k2 égal à R1.

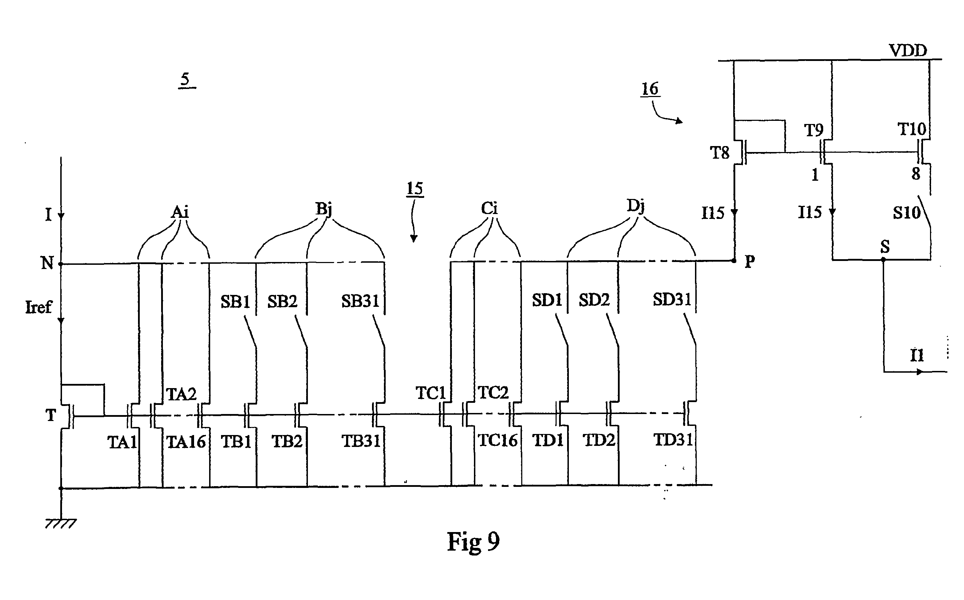

La figure 9 représente un mode de réalisation de l'amplificateur de courant 5 permettant de faire varier aisément le gain de l'amplificateur dans de grandes proportions. En figure 9, l'amplificateur 5 est formé de deux modules 15 et 16.

Le module 15 comporte un noeud d'entrée N recevant le courant I à amplifier (égal à I1-I0). Un transistor MOS connecté en diode, T, couple le noeud N à la masse et est parcouru par un courant Iref. 16 branches Ai, i allant de 1 à 16, relient le noeud N à la masse. Chaque branche Ai est constituée d'un transistor MOS TAi. La grille de chaque transistor TAi est reliée à la grille du transistor T. Chaque transistor TAi forme un miroir de courant avec le transistor T et est traversé par un courant égal à Iref. Le noeud N est également relié à la masse par trente et une branches identiques Bj, j allant de 1 à 31. Chaque branche Bj comprend un transistor TBj en série avec un interrupteur SBj. La grille de chaque transistor TBj est reliée à la grille du transistor T et, lorsque l'interrupteur SBj est fermé, le transistor TBj correspondant est parcouru par un courant égal à Iref. Les interrupteurs SBj sont commandables indépendamment les uns des autres et, si un nombre n d'interrupteurs SBj est ferme, le courant Iref est égal à I/(17+n). Lorsque tous les interrupteurs SBj sont ouverts, le courant Iref est égal à I/17 et, lorsque tous les interrupteurs SBj sont fermés, le courant Iref est égal à I/48.

Un noeud P forme la sortie du module 15. Seize branches Ci connectées en parallèle relient le noeud P à la masse. Chaque branche Ci est constituée d'un transistor MOS TCi. Chaque transistor TCi a sa grille reliée à la grille du transistor T et est parcouru par un courant égal à Iref. Le noeud P est également couplé à la masse par trente et une branches identiques Dj connectées en parallèle. Chaque branche Dj comprend un transistor MOS TDj en série avec un interrupteur SDj. La grille de chaque transistor TDj est reliée à la grille du transistor T. Lorsqu'un interrupteur SDj est fermé, le transistor TDj correspondant est parcouru par un courant égal à Iref. Le noeud P est traversé par un courant I15 égal à Iref x (16 + m), m étant le nombre d'interrupteurs SDj fermés. Les interrupteurs SBj et SDj sont commandés de sorte que si un interrupteur SBj est ouvert, l'interrupteur SDj correspondant est fermé et vice versa. Par conséquent, le nombre m d'interrupteurs SDj fermés est égal à (31-n), n étant le nombre d'interrupteurs SBj fermés.

Le gain G1 du module 15 peut varier entre 1/3 et 47/17. En effet, si tous les interrupteurs SBj sont fermés, le courant Iref est égal à I/48. Tous les interrupteurs SDj sont alors ouverts et le courant I15 est égal à Iref x 16. G1 est alors égal à I15/I soit 16/48 (1/3). Si tous les interrupteurs SBj sont ouverts, le courant Iref est égal à I/17. Tous les interrupteurs SDj sont fermés et le courant I15 est égal à Iref x 47. G1 est alors égal à I15/I soit 47/17 (2,7 environ).

Le module 16 a son entrée connectée au noeud P. Le module 16 comprend trois transistors MOS T8, T9 et T10. Le transistor T8 est connecté en diode. Il a sa source reliée au noeud P et son drain à la tension d'alimentation VDD. Le transistor T9 a son drain relié à la tension d'alimentation VDD et sa source à un noeud S constituant la sortie de l'amplificateur 5. La grille du transistor T9 est reliée à la grille du transistor T8. L'ensemble des transistors T8 et T9 réalise un miroir de courant. La géométrie des transistors T8 et T9 est choisie de sorte que le courant traversant le transistor T9 est égal au courant I15 traversant le transistor T8.

Le transistor T10 a son drain relié à la tension d'alimentation VDD. La grille du transistor T10 est reliée à la grille du transistor T8. La source du transistor T10 est reliée à la sortie S par l'intermédiaire d'un interrupteur S10. Les transistors T8 et T10 forment un miroir de courant. La géométrie des transistors T8 et T10 est choisie de sorte que, lorsqu'il débite, le transistor T10 est traversé par un courant égal à huit fois le courant I15 traversant le transistor T8. Ainsi, lorsque l'interrupteur S10 est fermé, le courant I1 fourni en sortie de l'amplificateur 5 est égal à 9 fois le courant I15.

Par le jeu d'ouverture et de fermeture des interrupteurs SBj, SDj et S10, le gain de l'amplificateur 5 peut varier de 1/3 à 47x9/17, soit 24,8 environ.

L'amplificateur en courant 5 de la figure 9 est particulièrement avantageux. D'une part, il est réalisé sous la forme de deux modules, ce qui permet d'obtenir aisément un gain plus important. Par ailleurs, les interrupteurs SBj, SDj et S10 peuvent être réalisés facilement sous la forme de transistors MOS commandés à l'ouverture ou à la fermeture par des signaux logiques 0 ou 1. Le module 15 est alors commandé par un nombre numérique N codé sur cinq bits, permettant d'obtenir des valeurs allant de 0 à 31. Les interrupteurs SBj seront par exemple commandés par le nombre N et les interrupteurs SDj par l'inverse du nombre N. Le signal de commande appliqué sur l'entrée G de l'amplificateur 5, est alors un nombre codé sur six bits, les cinq bits de poids faible (N) commandant le module 15 et le bit de poids fort commandant l'interrupteur S10 du module 16. Comme le gain du deuxième module a été choisi égal à 1 ou à 9, le gain de l'amplificateur 5 varie de façon monotone lorsque le nombre binaire de commande passe de 011111 à 100000. Une telle structure, que l'on dit linéaire en décibel, est particulièrement avantageuse car le gain est réglé facilement par une procédure numérique.

Bien entendu, la présente invention est susceptible de diverses variantes et modifications qui apparaîtront à l'homme de l'art. En particulier, on notera que les deux branches 1, 2, 5 et 1', 2', 5' ne sont pas nécessairement identiques, dans un circuit où les spécifications en matière de tensions d'erreur ne sont pas critiques.

En outre, bien que les amplificateurs de courant 5 et 5' aient été décrits comme étant à gain réglable, ils peuvent être à gain fixe, si la composante alternative de la tension V à normaliser ne varie pas de façon excessive.

Par ailleurs, on notera que la tension $V_0$ n'est pas nécessairement choisie sensiblement égale au niveau minimal de la tension à normaliser.

**Revendications**

1. Circuit pour normaliser un signal de tension comprenant :

   - un premier convertisseur tension-courant (1) recevant un signal de tension à normaliser (V) et une tension de référence (V0), et fournissant un courant proportionnel à la différence de tension entre la tension.du signal à normaliser et la tension de référence,
   - un premier amplificateur de courant (5) attaqué par le premier convertisseur tension-courant,
   - un deuxième convertisseur tension-courant (1') recevant une tension de réglage (Vreg) et la tension de référence (V0) et fournissant un courant proportionnel à la différence de tension entre la tension de réglage et la tension de référence,
   - un deuxième amplificateur de courant (5') attaqué par le deuxième convertisseur tension-courant, et
   - un moyen (7, 9) pour fournir un signal de tension normalisé à partir de la différence des courants fournis par les premier et deuxième amplificateurs de courant.

2. Circuit selon la revendication 1, dans lequel le moyen (7, 9) pour fournir le signal de tension normalisé comprend :

   - un moyen de conversion de courant (7) attaqué par le deuxième amplificateur de courant (5') et fournissant un courant de même amplitude et de sens opposé au courant qu'il reçoit, et
   - un convertisseur courant-tension (9) attaqué par le premier amplificateur de courant (5) et par le moyen de conversion de courant (7) et fournissant le signal de tension normalisé (VOUT).

3. Circuit selon une des revendications 1 ou 2, dans lequel les premier et deuxième amplificateurs de courant sont de constitution identique, de même que les premier et deuxième convertisseurs tension-courant.

4. Circuit selon la revendication 3, dans lequel les premier et deuxième amplificateurs de courant sont à gain variable et dans lequel leur gain est commandé de manière identique.

5. Circuit selon une des revendications précédentes, dans lequel chacun des premier et deuxième amplificateurs de courant comprend plusieurs modules amplificateurs.

6. Circuit selon la revendication 5, dans lequel chacun des premier et deuxième amplificateurs de courant comprend un premier module (15) et un deuxième module (16), le deuxième module assurant un gain en courant égal à 1 ou à 9.

7. Circuit selon la revendication 6, dans lequel le premier module (15) comprend :

   un noeud d'entrée (N) couplé à la masse par l'intermédiaire d'un transistor (T) connecté en diode, de 16 branches identiques (Ai) constituées chacune d'un transistor (TAi), et de 31 branches identiques (Bj) comprenant chacune un transistor (TBj) en série avec un interrupteur (SBj), chacun des transistors couplés au noeud d'entrée (N) étant traversé, lorsqu'il conduit, par un même courant (Iref), et
   un noeud de sortie (P) couplé à la masse par l'intermédiaire de 16 branches identiques (Ci) constituées chacune d'un transistor (TCi), et de 31 branches identiques (Dj) comprenant chacune un transistor (TDj) en série avec un interrupteur (SDj), chacun des transistors couplés au noeud de sortie (P) étant traversé, lorsqu'il conduit, par un courant de même valeur (Iref) qu'un quelconque, passant, des transistors couplés au noeud d'entrée.

8. Circuit selon une des revendications précédentes, dans lequel la tension de réglage (Vreg) est réglable et sert à régler la valeur minimale (Vbot) du signal normalisé.

9. Circuit selon une des revendications précédentes, **caractérisé en ce qu'**il comporte une première source de courant (3) disposée entre la sortie du premier convertisseur tension-courant (1) et une tension fixe (GND) et une deuxième source de courant (3') disposée entre la sortie du deuxième convertisseur tension-courant (1') et ladite tension fixe (GND).

10. Procédé pour normaliser un signal (V) à l'aide d'un circuit comprenant une première branche (1, 3, 5) recevant le signal à normaliser (V) et une deuxième branche (1', 3', 5') recevant une tension de réglage (Vreg), la première branche comportant un premier amplificateur de courant (5) à gain variable et la deuxième branche comportant un deuxième amplificateur de courant (5') à gain variable, les premier et deuxième amplificateurs de courant étant de constitution identique et leur gain (G) étant réglé de la même façon, comportant les étapes de réglage suivantes:

a) le gain (G) des premier et deuxième amplificateurs de courant étant réglé au maximum, injecter dans le circuit une tension égale à la valeur minimale (Vmin) de la tension à normaliser et régler la tension de réglage (Vreg) pour que le niveau minimal du signal en sortie du circuit corresponde au niveau minimum souhaité (Vbot), puis

b) injecter le signal à normaliser et régler le gain (G) des premier et deuxième amplificateurs de courant pour que le niveau maximal du signal en sortie du circuit corresponde au niveau maximal souhaité (Vtop).

## Claims

1. A circuit for calibrating a voltage signal, including:

- a first voltage-to-current converter (1) receiving a voltage signal to be calibrated (V) and a reference voltage ($V_0$), and providing a current proportional to the voltage difference between the voltage of the signal to be calibrated and the reference voltage,
- a first current amplifier (5) driven by the first voltage-to-current converter,
- a second voltage-to-current converter (1') receiving an adjustment voltage (Vreg) and the reference voltage ($V_0$) and providing a current proportional to the voltage difference between the adjustment voltage and the reference voltage,
- a second current amplifier (5') driven by the second voltage-to-current converter, and
- means (7, 9) for providing a calibrated voltage signal based on the difference between the currents provided by the first and second current amplifiers.

2. The circuit of claim 1, wherein said means (7, 9) for providing a calibrated voltage signal includes:

- a current conversion means (7) driven by the second current amplifier (5') and providing a current of same amplitude and of sign opposite to that of the current that it receives, and
- a current-to-voltage converter (9) driven by the first current amplifier (5) and by the current conversion means (7) and providing the calibrated voltage signal (VOUT).

3. The circuit of claim 1 or 2, wherein the first and second current amplifiers, as well as the first and second voltage-to-current converters, have an identical structure.

4. The circuit of claim 3, wherein the first and second current amplifiers have a variable gain and their gain is identically controlled.

5. The circuit of any of the preceding claims, wherein each of the first and second current amplifiers includes several amplifier units.

6. The circuit of claim 5, wherein each of the first and second current amplifiers includes a first unit (15) and a second unit (16), the second unit ensuring a current gain equal to 1 or to 9.

7. The circuit of claim 6, wherein the first unit (15) includes:

an input node (N) coupled to ground via a diode-connected transistor (T), 16 identical branches (Ai), each formed of a transistor (TAi), and 31 identical branches (Bj), each including a transistor (TBj) in series with a switch (SBj), each of the transistors coupled to the input node (N) being flown, when on, by a same current (Iref), and

an output node (P) coupled to ground via 16 identical branches (Ci), each formed of a transistor (TCi), and 31 identical branches (Dj), each including a transistor (TDj) in series with a switch (SDj), each of the transistors coupled with the output node (P) being flown, when on, by a current of same value (Iref) as any each transistor coupled with the input node, in the on state.

8. The circuit of any of the preceding claims, wherein the adjustment voltage (Vreg) is adjustable and is used to set the minimum value (Vbot) of the calibrated signal.

9. The circuit of any of the preceding claims, including a first current source (3) arranged between the output of the first voltage-to-current converter (1) and a fixed voltage (GND), and a second current source (3') arranged between the output of the second voltage-to-current converter (1') and said fixed voltage (GND).

10. A method for calibrating a signal (V) by means of a circuit including a first branch (1, 3, 5) receiving the signal to be calibrated (V) and a second branch (1', 3', 5') receiving an adjustment voltage (Vreg), the first branch including a first variable-gain current amplifier (5) and the second branch including a second variable-gain current amplifier (5'), the first and second current amplifiers being of identical structure and their gain (G) being set in the same way, including the adjustment steps of:

   a) the gain (G) of the first and second current amplifiers being adjusted to its maximum value, injecting into the circuit a voltage equal to the minimum value (Vmin) of the voltage to be calibrated and adjusting the adjustment voltage (Vreg) so that the minimum level of the signal at the circuit output corresponds to the desired minimum level (Vbot), then
   b) injecting the signal to be calibrated and adjusting the gain (G) of the first and second current amplifiers so that the maximum level of the signal at the circuit output corresponds to the desired maximum level (Vtop).


**Patentansprüche**

1. Eine Schaltung zum Kalibrieren eines Spannungssignals, die Folgendes aufweist:

   - einen ersten Spannung-zu-Strom-Wandler (1), der ein zu kalibrierendes Spannungssignal (V) und eine Bezugsspannung ($V_0$) empfängt und zum Vorsehen einer Spannung, die proportional zu der Spannungsdifferenz zwischen der Spannung des zu kalibrierenden Signals und der Referenzspannung ist,
   - einen ersten Stromverstärker (5), der durch den ersten Spannung-zu-Strom-Wandler getrieben wird,
   - einen zweiten Spannung-zu-Strom-Wandler (1'), der eine Einstellspannung (Vreg) und die Bezugsspannung ($V_0$) empfängt und zum Vorsehen eines Stroms der proportional zu der Spannungsdifferenz zwischen der Einstellspannung und der Referenzspannung ist,
   - einen zweiten Stromverstärker (5'), der durch den zweiten Spannung-zu-Strom-Wandler getrieben wird, und
   - Mittel (7, 9) zum Vorsehen eines kalibrierten Spannungssignals basierend auf der Differenz zwischen den Strömen, die durch die ersten und zweiten Stromverstärker vorgesehen werden.

2. Schaltung nach Anspruch 1, wobei die Mittel (7, 9) zum Vorsehen eines kalibrierten Spannungssignals Folgendes aufweisen:

   - Stromwandlermittel (7), die durch den zweiten Stromverstärker (5') getrieben werden, und zum Vorsehen eines Stroms mit der selben Amplitude und einem entgegengesetzten Vorzeichen zu dem Strom, den sie empfangen, und
   - einen Strom-zu-Spannung-Wandler (9), der durch den ersten Stromverstärker (5) und die Stromwandlermittel (7) getrieben werden und zum Vorsehen des kalibrierten Spannungssignals (VOUT).

3. Schaltung nach Anspruch 1 oder 2, wobei die ersten und zweiten Stromverstärker sowie die ersten und zweiten Spannung-zu-Strom-Wandler eine identische Struktur besitzen.

4. Schaltung nach Anspruch 3, wobei die ersten und zweiten Stromverstärker eine variable Verstärkung besitzen, und ihre Verstärkung identisch gesteuert wird.

5. Schaltung nach einem der vorhergehenden Ansprüche, wobei jeder der ersten und zweiten Stromverstärker mehrere Verstärkereinheiten aufweist.

6.  Schaltung nach Anspruch 5, wobei jeder der ersten und zweiten Stromverstärker eine erste Einheit (15) und eine zweite Einheit (16) aufweist, wobei die zweite Einheit eine Stromverstärkung von gleich 1 oder 9 vorsieht.

7.  Schaltung nach Anspruch 6, wobei die erste Einheit (15) Folgendes aufweist:

    einen Eingangsknoten (N), der mit Erde gekoppelt ist über einen Dioden verbundenen Transistor (T), 16 identische Zweige (Ai), die jeweils aus einem Transistor (TAi) gebildet werden, und 31 identische Zweige (Bj), die jeweils einen Transistor (TBj) in Serie mit einem Schalter (SBj) aufweisen, wobei jeder der Transistoren, der mit dem Eingangsknoten (N) verbunden ist, durch denselben Strom (Iref) durchflossen wird, wenn er an ist, und einen Ausgangsknoten (P), der mit Erde gekoppelt ist über 16 identische Zweige (Ci), die jeweils aus einem Transistor (TCi) gebildet werden und 31 identische Zweige (Dj), die jeweils einen Transistor (TDj) in Serie mit einem Schalter (SDj) aufweisen, wobei jeder der Transistoren, der mit dem Ausgangsknoten (P) gekoppelt ist durch einen Strom des selben Werts (Iref) durchströmt wird, wenn er an ist, wie jeder Transistor, der mit dem Eingangsknoten gekoppelt ist, und sich im An-Zustand befindet.

8.  Schaltung nach einem der vorhergehenden Ansprüche, wobei die Einstellspannung (Vreg) einstellbar ist, und verwendet wird zum Einstellen des Minimalwerts (Vbot) des kalibrierten Signals.

9.  Schaltung nach einem der vorhergehenden Ansprüche, die ferner Folgendes aufweist: eine erste Stromquelle (3), die zwischen dem Ausgang des ersten Spannung-zu-Strom-Wandlers (1) und einer festen Spannung (GND) angeordnet ist, und eine zweite Stromquelle (3'), die zwischen dem Ausgang des zweiten Spannung-zu-Strom-Wandlers (1') und der festen Spannung (GND) angeordnet ist.

10. Verfahren zum Kalibrieren eines Signals (V) mittels einer Schaltung, die Folgendes aufweist: einen ersten Zweig (1, 3, 5), der das zu kalibrierende Signal (V) empfängt und einem zweiten Zweig (1', 3', 5'), der eine Einstellspannung (Vreg) empfängt, wobei der erste Zweig einen ersten Stromverstärker (5) mit variabler Verstärkung aufweist und der zweite Zweig einen zweiten Stromverstärker (5') mit variabler Verstärkung aufweist, wobei die ersten und zweiten Stromverstärker eine identische Struktur besitzen und ihre Verstärkung (G) in derselben Art und Weise eingestellt wird, einschließlich der folgenden Einstellschritte:

    a) die Verstärkung (G) der ersten und zweiten Stromverstärker wird auf ihre Maximalwerte eingestellt, Einführen einer Spannung gleich dem Minimalwert (Vmin) der zu kalibrierenden Spannung in die Schaltung und Einstellen der Einstellspannung (Vreg), so dass das minimale Niveau des Signals am Schaltungsausgang dem gewünschten Minimalniveau (Vbot) entspricht, und dann

    b) Einführen des zu kalibrierenden Signals und Einstellen der Verstärkung (G) der ersten und zweiten Stromverstärker, so dass das maximale Niveau des Signals am Schaltungsausgang dem gewünschten Maximalniveau (Vtop) entspricht.

Fig 1

Fig 2

Fig 3

EP 1 362 419 B1

18

I2 ↓                    I2 ↓

T1                      T2

Fig 4

I1

Im

|ΔV|    |ΔV|

0        V₀        Vmax    V

Fig 5

V OUT

Vtop

Vbot

0                    i max    i

Fig 6

Fig 7

Fig 8

Fig 9

EP 1 362 419 B1

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 0993110 A